## (19) Europäisches Patentamt
### European Patent Office
### Office européen des brevets

(11) **EP 1 235 346 B1**

(12) **EUROPÄISCHE PATENTSCHRIFT**

(45) Veröffentlichungstag und Bekanntmachung des Hinweises auf die Patenterteilung:
**07.06.2006 Patentblatt 2006/23**

(51) Int Cl.:
*H03G 5/18* (2006.01)   *H03G 5/02* (2006.01)

(21) Anmeldenummer: **02001438.7**

(22) Anmeldetag: **21.01.2002**

(54) **Entzerreranordnung und Verfahren zum Erzeugen eines Ausgangssignals durch Entzerren eines Eingangssignals**

Equalizer device and method of generating an output signal by equalizing an input signal

Dispositif égaliseur et méthode de génération d'un signal de sortie par égalisation d'un signal d'entrée

(84) Benannte Vertragsstaaten:
**AT BE CH CY DE DK ES FI FR GB GR IE IT LI LU MC NL PT SE TR**

(30) Priorität: **22.02.2001 DE 10108664**

(43) Veröffentlichungstag der Anmeldung:
**28.08.2002 Patentblatt 2002/35**

(73) Patentinhaber: **Harman Becker Automotive Systems GmbH**
**76307 Karlsbad (DE)**

(72) Erfinder: **Azizi, Seyed Ali**
**72800 Eningen (DE)**

(74) Vertreter: **Schmuckermaier, Bernhard**
**PAe Westphal, Mussgnug & Partner,**
**Mozartstrasse 8**
**80336 München (DE)**

(56) Entgegenhaltungen:
**US-A- 5 714 918**

## EP 1 235 346 B1

**Beschreibung**

Die Erfindung betrifft eine Entzerreranordnung und ein Verfahren zum Erzeugen eines Ausgangssignals durch Entzerren eines Eingangssignals.

Entzerreranordnungen wie beispielsweise Entzerrerbänke bestehen aus einem Satz von Entzerrern (Equalizer), die in einer bestimmten Weise miteinander verschaltet sind unter Verwendung einer seriellen, parallelen oder irgend einer anderen Struktur. Die einzelnen Entzerrer können Anhebungsentzerrer (Presence Equalizer) oder Absenkungsentzerrer (Absence Equalizer) sein, d.h. Entzerrer mit einer Verstärkungsanhebung bzw. einer Verstärkungsabsenkung (Dämpfungsanhebung) bei der jeweiligen Mittenfrequenz, wobei das Dämpfungsmaß im folgenden immer als negatives Verstärkungsmaß in dB angegeben wird.

Ein Entzerrerbänken innewohnendes Problem ist es, dass das Übertragungsverhalten der einzelnen Entzerrer innerhalb der Entzerrerbank miteinander interferieren und damit zwei höchst unerwünschte Nachteile von Entzerrerbänken nach sich ziehen. Zum einen können sich je nach Einstellung bei bestimmten Frequenzen und Frequenzbereichen ausgeprägte Verstärkungs- bzw. Dämpfungsüberhöhungen ergeben und zum anderen eine mehr oder weniger starke Verzerrung des Übertragungsverhaltens auftreten.

Aufgabe der Erfindung ist es, eine Entzerreranordnung und ein Verfahren der eingangs genannten Art anzugeben, bei dem diese Nachteile nicht auftreten.

Ein Entzerrerbank wobei die unerwünschte Nachteile die miteinander interferierenden einzelnen Entzerrer nicht oder weniger auftreten, ist beschrieben in Patentschrift US 5,714,918 A1. Hierbei handelt es sich um ein Entzerreranordnung mit in Reihe zueinander geschalteten Parallelschaltungen von unabhängig einstellbaren Hochpass- und Tiefpassfilter.

Erfindungsgemäss wird die Aufgabe gelöst durch eine Entzerreranordnung gemäß Patentanspruch 1 bzw. durch ein Verfahren gemäß Patentanspruch 9. Ausgestaltungen und Weiterbildungen des Erfindungsgedankens sind Gegenstand von Unteransprüchen.

Eine erfindungsgemäße Entzerreranordnung und ein erfindungsgemäßes Verfahren zeichnet sich gegenüber üblichen Entzerrerbänken dadurch aus, dass das Ausmaß der Interferenzen ausreichend verringert wird, indem die interferierende Wirkung zumindest eines benachbarten Entzerrers, vorzugsweise zwei benachbarter Entzerrer bei der Mittenfrequenz des jeweiligen Entzerrers berücksichtigt wird. Die Erfindung basiert im wesentlichen darauf, die interferierende Wirkung jedes einzelnen Entzerrers auf seine benachbarten Entzerrer bei deren Mittenfrequenzen zu bestimmen und daraus Korrekturgrößen abzuleiten. Mit diesen Korrekturgrößen werden dann korrespondierende Korrekturentzerrer mit entgegengesetzten Verhalten derart angesteuert, dass die interferierenden Wirkungen kompensiert werden.

Im einzelnen umfasst eine erfindungsgemäße Entzerreranordnung mindestens zwei erste Entzerrer und mindestens zwei zweite Entzerrer (Korrekturentzerrer), die in Reihe zueinander geschaltet sind, wobei jeweils ein zweiter Entzerrer mit jeweils einem ersten Entzerrer korrespondiert derart, dass jeweils korrespondierende erste und zweite Entzerrer zwar die gleiche Mittenfrequenz haben, die korrespondierenden zweiten Entzerrer jedoch ein die Interferenzen zumindest teilweise kompensierendes Entzerrungsverhalten aufweisen. Dabei ist die Verstärkung des jeweils korrespondierenden zweiten Entzerrers bei der jeweiligen gemeinsamen Mittenfrequenz gleich der negativen Summe über die Verstärkung mindestens eines dem korrespondierenden ersten Entzerrer benachbarten ersten Entzerrers bei der Mittenfrequenz des korrespondierenden ersten Entzerrers.

Dem entsprechend sieht ein erfindungsgemäßes Verfahren vor, zunächst das Eingangssignal bei mindestens zwei Mittenfrequenzen mit einen bestimmten Entzerrungsverhalten zu entzerren (erste Entzerrung) und anschließend bei den selben mindestens zwei Mittenfrequenzen mit einem die Interferenzen zumindest teilweise kompensierenden Entzerrungsverhalten zusätzlich zu entzerren (zweite Entzerrung, Korrektur-Entzerrung). Dabei ist wiederum die Verstärkung (Korrektur-Verstärkung) der jeweils korrespondieren zweiten Entzerrungen bei der jeweiligen gemeinsamen Mittenfrequenz die negative Summe über die Verstärkung(en) mindestens einer der korrespondierenden ersten Entzerrung benachbarten ersten Entzerrungen bei der Mittenfrequenz der korrespondierenden ersten Entzerrung.

Somit wird die Verstärkung jedes Entzerrers der Entzerrerbank bei der Mittenfrequenz mindestens eines benachbarten Entzerrers berechnet oder abgeschätzt. Dieser Wert dient dann zur Einstellung des bzw. der zu den benachbarten Entzerrern korrespondierenden Entzerrer (Korrekturentzerrern). Für jede einzelne Mittenfrequenz können dann die so ermittelten Verstärkungswerte (in dB) vorzeichenrichtig aufsummiert werden, so dass bei jeder Mittenfrequenz ein bestimmter Verstärkungswert (bzw. Dämpfungswert) für jeden korrespondierenden Entzerrer (Korrekturentzerrer) bereitgestellt wird. Die Verstärkung eines jeden korrespondierenden zweiten Entzerrers (Korrekturentzerrers) ist gleich dem negativen für den korrespondierenden ersten Entzerrer errechneten Interferenzwert bei dessen Mittenfrequenz.

Darüber hinaus kann neben der Verstärkung auch die Phasenlage bei der jeweiligen Mittenfrequenz berücksichtigt wird, so dass anstelle einer rein reellen Berechnung auch eine komplexe Berechnung ermöglicht wird.

Bevorzugt setzt sich die Verstärkung des jeweiligen zweiten Entzerrers aus den negativen Verstärkungen des dem korrespondierenden ersten Verstärkers voraus gehenden ersten Entzerrers und des dem korrespondierenden ersten Entzerrer nachfolgenden ersten Entzerrers bei der Mittenfrequenz des korrespondierenden ersten Entzerrers zusammen. Darüber hinaus kann die Verstärkung des jeweiligen zweiten Entzerrers (Korrekturentzerrers) zudem auch die negativen Verstärkungen weiterer benachbarter erster Entzerrer bei der Mittenfrequenz des korrespondierenden ersten Entzerrers beinhalten.

Die Anordnung der Entzerrer kann dabei derart sein, dass entweder die ersten Entzerrer jeweils unmittelbar hintereinander und die zweiten Entzerrer jeweils unmittelbar hintereinander geschaltet sind oder zum anderen jeweils ein erster und zweiter Entzerrer unmittelbar hintereinander geschaltet sind.

Bevorzugt weisen die ersten und zweiten Entzerrer jeweils eine im wesentlichen konstante vorgegebene Verstärkung auf (wie beispielsweise die Verstärkung 1 entsprechend 0 dB), die jedoch im Bereich der Mittenfrequenz gegenüber dem im wesentlichen konstanten Wert angehoben oder abgesenkt ist. Die Mittenfrequenz kann dabei entweder fest vorgegeben sein (grafische Entzerrerbank) oder aber veränderbar sein (parametrische Entzerrerbank). Im Falle parametrischer Entzerrer können auch andere Merkmale des Übertragungsverhaltens einstellbar sein.

Die Erfindung wird nachfolgend anhand der in den Figuren der Zeichnung dargestellten Ausführungsbeispiele näher erläutert. Es zeigt:

Figur 1      eine erste Ausführungsform einer als parametrische Entzerrerbank ausgebildeten erfindungsgemäßen seriellen Entzerreranordnung,

Figur 2      eine zweite Ausführungsform einer als grafische Entzerrerbank ausgebildeten erfindungsgemäßen seriellen Entzerreranordnung,

Figur 3      das Übertragungsverhalten bevorzugter Entzerrer bei den Ausführungsbeispielen nach den Figuren 1 und 2,

Figuren 4-6      das Übertragungsverhalten erfindungsgemäßer Entzerreranordnungen im Vergleich zu herkömmlichen Entzerreranordnungen und

Figur 7      eine Ausführungsform einer als parametrische Entzerrerbank ausgebildeten erfindungsgemäßen parallelen Entzerreranordnung.

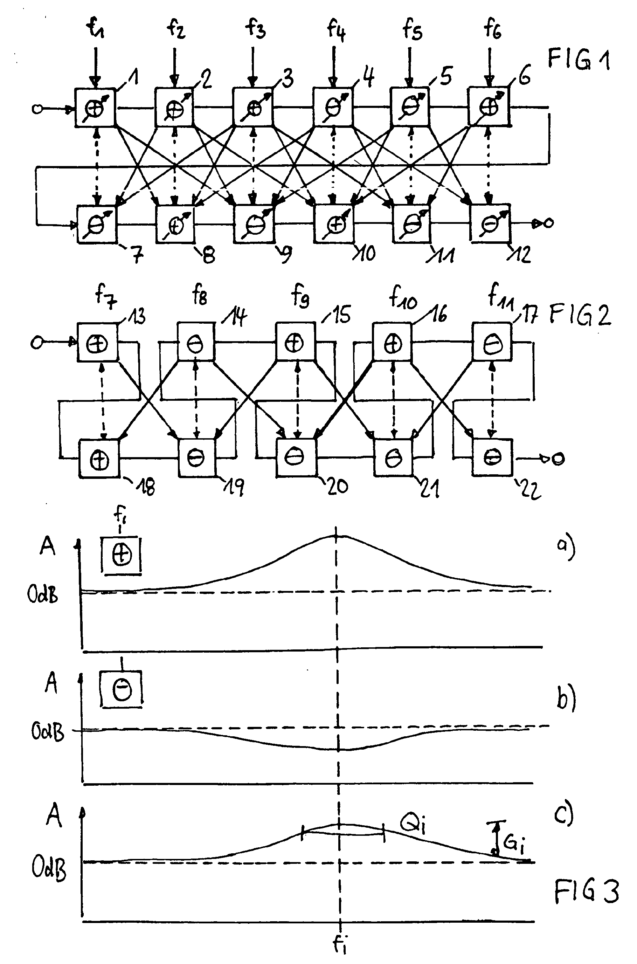

Bei dem Ausführungsbeispiel nach Figur 1 sind sechs erste Entzerrer 1 bis 6 hintereinander geschaltet, die jeweils eine Mittenfrequenz $f_1$ bis $f_6$ aufweisen und die das Übertragungsverhalten der gesamten Entzerreranordnung wesentlich vorgeben sollen. Den sechs ersten Entzerrern 1 bis 6 folgen sechs zweite Entzerrer 7 bis 12, wobei jeweils einer der ersten Entzerrer 1 bis 6 mit jeweils einem der zweiten Entzerrer 7 bis 12 korrespondiert derart, dass die miteinander korrespondierenden ersten und zweiten Entzerrer 1 bis 6, 7 bis 12 die gleiche Mittenfrequenz $f_1$ bis $f_6$ aufweisen. Die Mittenfrequenzen $f_1$ bis $f_6$ sind sowohl bei den ersten Entzerrern 1 bis 6 als auch bei den zweiten Entzerrers 7 bis 12 in gleicher Weise veränderbar, so dass die in Figur 1 gezeigte Entzerreranordnung eine parametrische Entzerrerbank darstellt. Beispielsweise sind die jeweils korrespondierenden Entzerrer identisch aufgebaut.

Des Weiteren korrespondieren erste und zweite Entzerrer 1 bis 6, 7 bis 12 dahingehend, dass die jeweils korrespondierenden zweiten Entzerrer 7 bis 12 ein zu den Interferenzwirkungen auf den korrespondierenden ersten Entzerrer durch die benachbarten ersten Entzerrer entgegengesetztes Entzerrungsverhalten aufweisen. In Figur 1 sind beispielsweise die ersten Entzerrer 1, 2, 3, 6 Anhebungsentzerrer und die ersten Entzerrer 4, 5 Absenkungsentzerrer. Dem gegenüber sind die zweiten Entzerrer 8, 10 Anhebungsentzerrer und die zweiten Entzerrer 7, 9, 11, 12 Absenkungsentzerrer entsprechend der Interferenzwirkung der den korrespondieren ersten Entzerrern benachbarten ersten Entzerrer.

Anhebungsentzerrer haben dabei bei der jeweiligen Mittenfrequenz gegenüber einer Grundverstärkung eine Verstärkungsanhebung, während Absenkungsentzerrer gegenüber der Grundverstärkung eine Verstärkungsabsenkung bei der Mittenfrequenz aufweisen. Die Funktionsweise von Absenkungsentzerrern und Anhebungsentzerrern ist weiter unten in Figur 3 detaillierter dargestellt.

Die Verstärkung (+) bzw. Dämpfung (-) der als Anhebungsentzerrer bzw. Absenkungsentzerrer ausgebildeten zweiten Entzerrer 7 bis 12 ergibt sich dabei aus der Interferenz (dem Übersprechen) der dem jeweiligen korrespondierenden ersten Entzerrer 1 bis 6 benachbarten ersten Entzerrer 1 bis 6 bei der gemeinsamen Mittenfrequenz f1 bis f6 der jeweils korrespondierenden ersten und zweiten Entzerrern 1 bis 6, 7 bis 12. Beim vorliegenden Ausführungsbeispiel werden die - sofern vorhanden - beiden jeweils zu beiden Seiten eines ersten korrespondierenden Entzerrers benachbarten ersten Entzerrer für die Berechnung des korrespondierenden zweiten Entzerrers 7 bis 12 ausgewertet.

Im Falle des Entzerrers 1 existieren lediglich zwei benachbarte Entzerrer, nämlich die Entzerrer 2 und 3, die auf einer Seite des Entzerrers 1 angeordnet sind. Der zum ersten Entzerrer 1 korrespondierende zweite Entzerrer 7 bildet aufgrund seines dem jeweiligen Gesamtübersprechen entgegengesetzten Entzerrungsverhalten den Einfluss der beiden benachbarten ersten Entzerrer 2 und 3 bei der Mittenfrequenz f1 der beiden korrespondierenden ersten und zweiten Entzerrer 1, 7 entgegengesetzt nach, so dass der Einfluss der beiden ersten Entzerrer 2 und 3 auf den ersten Entzerrer 1 kompensiert wird. Der Betrag der Dämpfung des zweiten Entzerrers 7 entspricht dabei dem Betrag der Verstärkung bei der Mittenfrequenz $f_1$, der durch die beiden ersten Entzerrer 2 und 3 hervorgerufen wird.

Bei der Mittenfrequenz $f_3$ des ersten Entzerrers 3 wirken beispielsweise auch die ersten Entzerrer 1 und 2 vor dem ersten Entzerrer 3 sowie die ersten Entzerrer 4 und 5 nach dem Entzerrer 3. Der Einfluss des um drei Stellen benachbarten ersten Entzerrers 6 ist dabei vernachlässigbar. Zu dem ersten Entzerrer 3 korrespondiert der zweite Entzerrer 9, der den Einfluss der ersten Entzerrer 1, 2, 4 und 5 kompensieren soll. Der Betrag der Dämpfung des zweiten Entzerrers 9 ist gleich dem Betrag der Verstärkung bei der mit dem korrespondierenden Entzerrers 3 gemeinsamen Mittenfrequenz $f_3$, die durch ersten Entzerrer 1, 2, 4 und 5 bei der Mittenfrequenz $f_3$ gemeinsam hervorgerufen wird. Diese Verstärkung ergibt sich also aus den einzelnen Verstärkungen und Dämpfungen der ersten Entzerrer 1, 2, 4 und 5 bei der Mittenfrequenz $f_3$. Die Kompensation bei den verbleibenden Mittenfrequenzen $f_2$, $f_4$, $f_5$ und $f_6$ erfolgt in entsprechender Weise.

Die Ermittlung der Verstärkungen bzw. Dämpfungen der zweiten Entzerrer 7 bis 12 erfolgt durch Berechnung oder Abschätzung aus der Übertragungsfunktion der benachbarten ersten Entzerrer 1 bis 6 oder durch Messung der durch die benachbarten ersten Entzerrer 1 bis 6 hervorgerufenen Signale bei der jeweiligen Mittenfrequenz.

In Figur 2 ist eine als grafische Entzerrerbank ausgebildete erfindungsgemäße Entzerreranordnung gezeigt, die fünf erste Entzerrer 13 bis 17 sowie fünf zweite Entzerrer 18 bis 22 aufweist. Dabei korrespondieren jeweils ein erster und ein zweiter Entzerrer derart, dass sie die gleiche Mittenfrequenz aufweisen. Das Entzerrungsverhalten der zweiten Entzerrer wird von der Interferenzwirkung bei den jeweiligen Mittenfrequenzen bestimmt. Erste und zweite Entzerrer 13 bis 22 sind so angeordnet, dass korrespondierende erste und zweite Entzerrer jeweils unmittelbar aufeinander folgen und die Paare korrespondierender Entzerrer 13 bis 22 einander in Reihe geschaltet sind. Da es sich um eine grafische Entzerrerbank handelt, sind demzufolge die Mittenfrequenzen $f_7$ bis $f_{11}$ fest. In diesem Fall können die zweiten Entzerrer 18 bis 22 fest auf die jeweils korrespondierenden ersten Entzerrer 13 bis 17 sowie deren benachbarte erste Entzerrer eingestellt werden, d. h., dass die zweiten Entzerrer 18 bis 22 ebenfalls als feste (bevorzugt identische) Entzerrer ausgebildet werden können.

Beim Ausführungsbeispiel nach Figur 2 werden nur die jeweils unmittelbar benachbarten ersten Entzerrer 13 bis 17 zur Interferenz-Kompensation ausgewertet. Der Einfluss der dem ersten Entzerrer 15 benachbarten ersten Entzerrer 14 und 16 kann dabei - wie nachfolgend dargelegt - formal ausgedrückt werden.

Ausgangsgrößen sind dabei die jeweiligen Verstärkungen $G_i$ (in dB) der ersten Entzerrer 13 bis 17, die jeweilige Güte $Q_i$ der ersten Entzerrer 13 bis 17 bzw. die jeweiligen Verstärkungen $G_k$ (in dB) der zweiten Entzerrer 18 bis 22 bzw. die jeweilige Güte $Q_k$ der zweiten Entzerrer 18 bis 22, die jeweilige Mittenfrequenz $f_i$ der ersten Entzerrer 13 bis 17 bzw. die jeweilige Mittenfrequenz $f_k$ der zweiten Entzerrer 18 bis 22 sowie der Wert $K_{ji}$ (in dB) entsprechend der Verstärkung eines ersten Entzerrers 11 bis 17 mit einer Mittenfrequenz $f_j$ bei der Mittenfrequenz $f_i$ und damit das Übersprechen (Interferenz) eines Entzerrers mit der Mittenfrequenz $f_j$ auf den Entzerrer mit der Mittenfrequenz $f_i$.

Daraus ergibt sich für das gesamte Übersprechen $K_i$ aus den beiden benachbarten Kanälen j=i+1 und j=i-1:

$$K_i = K_{(i+1)i} + K_{(i-1)i}.$$

Die Verstärkung des zum ersten Entzerrer i korrespondierenden zweiten Entzerrers k ist damit:

$$G_k = -K_i.$$

Im Übrigen gilt für zwei jeweils korrespondierende erste und zweite Entzerrer i und k mit $f_i = f_k$:

$$Q_k = \alpha \cdot Q_i \quad \text{mit } 0,5 \leq \alpha \leq 2$$

Ausgehend von einer Anordnung nach Figur 2 ist in Figur 3, Diagramm a) exemplarisch der Verlauf eines innerhalb einer Entzerrerbank angeordneten ersten Entzerrers alleine gezeigt, wobei das Übersprechen benachbarter Entzerrer in dem gezeigten Verlauf schematisch enthalten ist (Verstärkungsüberhöhung). In dem Diagramm b) ist der Verlauf der Verstärkung A (in dB) über der Frequenz f eines zu dem im Diagramm a) dargestellten ersten Entzerrer korrespondierenden zweiten Entzerrers (Korrekturentzerrer) gezeigt, dessen Verlauf dem entgegengesetzten Verlauf des durch die benachbarten ersten Entzerrer bei dem korrespondierenden ersten Entzerrer hervorgerufenen Übersprechen entspricht.

Durch das Hintereinanderschalten von korrespondierenden ersten und zweiten Entzerrern ergibt sich insgesamt ein Verlauf, der in dem Diagramm c) aus Figur 3 dargestellt ist. Dieser Verlauf entspricht dem eingestellten und damit gewünschten Verlauf, da der Einfluss benachbarter Entzerrer kompensiert wird. Der Verlauf ist dabei insbesondere charakterisiert durch die Mittenfrequenz $f_i$, die Güte $Q_i$ und die Verstärkung $G_i$ bei der Mittenfrequenz $f_i$.

Die Figuren 4 bis 6 zeigen jeweils in den Diagrammen a) den Verlauf einer Entzerrerbank mit sieben einzelnen Entzerrern ohne korrespondierende Entzerrer (Korrekturentzerrer) und in den jeweiligen Diagrammen b) mit korrespondierenden Entzerrern (Korrekturentzerrer) gemäß der Erfindung. Dabei wird von folgenden Grundeinstellungen bei den einzelnen Ausführungsbeispielen nach den Figuren 4 bis 6 ausgegangen (Die Pfeile weisen auf die voreingestellten Anhebungen bzw. Absenkungen bei den jeweiligen Mittenfrequenzen hin) :

| Entzerrer | 1 | 2 | 3 | 4 | 5 | 6 | 7 |
| --- | --- | --- | --- | --- | --- | --- | --- |
| Frequenz (Hz) | 80 | 200 | 500 | 1k | 2k | 5k | 12k |
| Verstärkung (dB) in Fig. 4 | +10 | +10 | +10 | +10 | +10 | +10 | +10 |
| Verstärkung (dB) in Fig. 5 | 0 | 0 | -10 | +10 | 0 | 0 | 0 |
| Verstärkung (dB) in Fig. 6 | +10 | +10 | +10 | -10 | +10 | +10 | +10 |

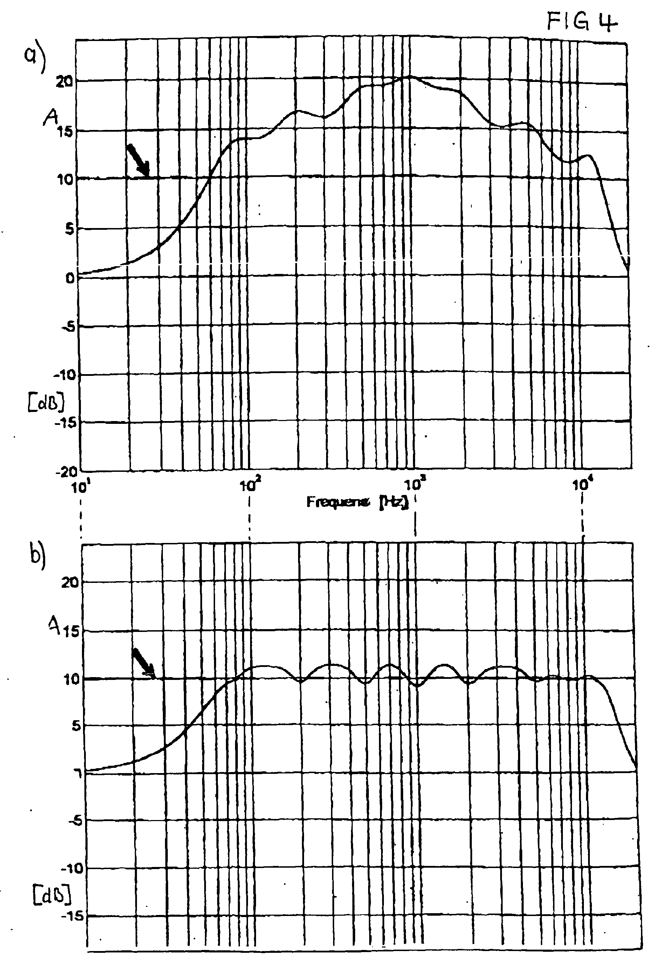

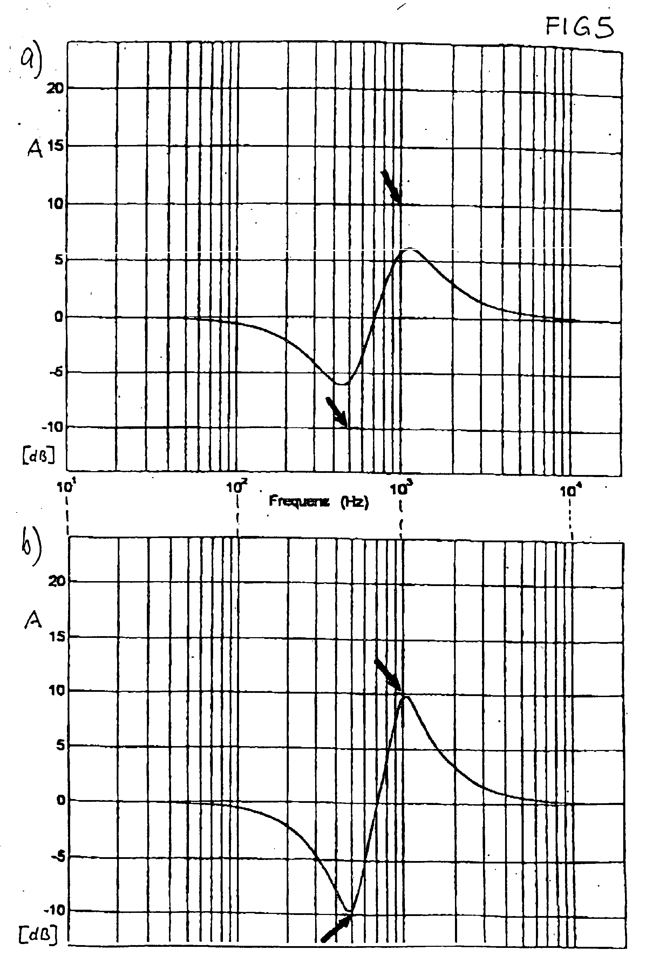

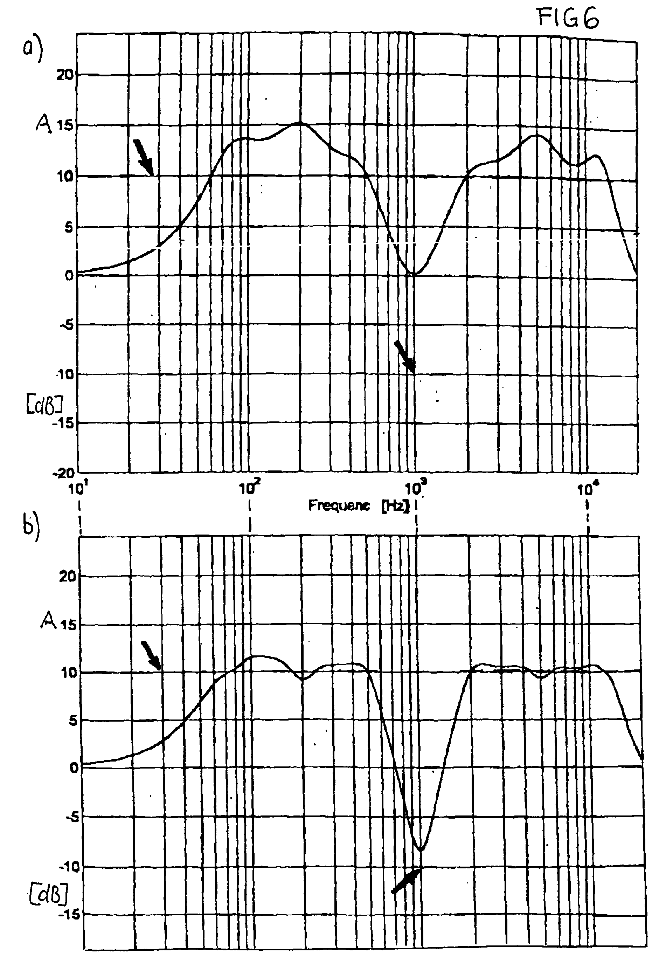

In Figur 4 wird unerwünschte Verstärkungsüberhöhung, in Figur 5 unerwünschte Verstärkungsabsenkung und in Figur 6 unerwünschte Verzerrungen des Übertragungsverhaltens deutlich verringert, wobei bei den in den Figuren 4 bis 6 nur die beiden jeweils unmittelbar benachbarten Entzerrer ausgewertet wurden. Es konnten auf diese Weise Überhöhungen bis zu 15 dB kompensiert werden.

Mit den gezeigten Entzerreranordnungen werden jeweils Verfahren durchgeführt, bei denen ein erstes Entzerren des Eingangssignals bei mindestens zwei Mittenfrequenzen mit einem bestimmten Entzerrungsverhalten, ein korrespondierendes zweites Entzerren des Eingangssignals bei den selben mindestens zwei Mittenfrequenzen mit einem Interferenzen kompensierenden Entzerrungsverhalten erfolgt, wobei die Verstärkung der jeweils korrespondierenden Entzerrungen(Korrekturentzerrungen) bei der jeweiligen gemeinsamen Mittenfrequenz die negative Verstärkung mindestens eines der korrespondierenden ersten Entzerrung benachbarten ersten Entzerrung bei der Mittenfrequenz der korrespondierenden ersten Entzerrung beinhaltet. Ein derartiges Verfahren kann bevorzugt auch in einem analogen sowie digitalen Signalprozessor implementiert werden.

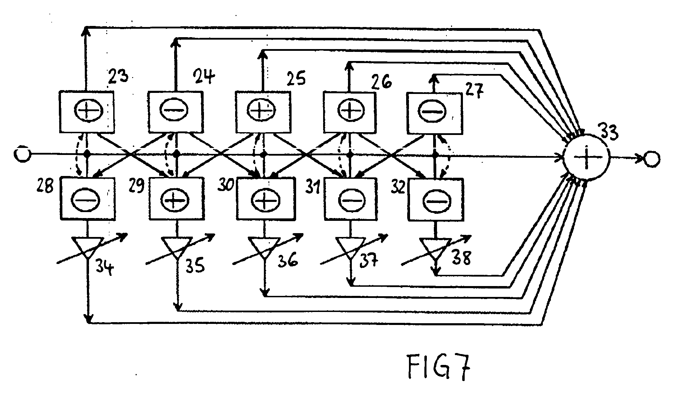

Bei dem in Figur 7 gezeigten Ausführungsbeispiel ist vom Eingang zum Ausgang ein Pfad mit konstanter Verstärkung geführt. Beim Ausführungsbeispiel ist die Verstärkung gleich eins (entsprechend 0 dB), sie kann jedoch auch beliebige Werte für die Verstärkung/Dämpfung annehmen. Alle eingesetzten ersten Entzerrer 23 bis 27 und zweiten Entzerrer 28 bis 32 sind Bandpassfilter mit hoher Dämpfung unterhalb einer unteren Grenzfrequenz, hoher Dämpfung oberhalb einer oberen Grenzfrequenz und variabler Verstärkung bei der Mittenfrequenz.

Sämtliche Entzerrer 23 bis 32 sind eingangsseitig einander parallel geschaltet und mit dem Eingang der Entzerrerbank gekoppelt. Ausgangsseitig sind sämtliche Entzerrer 23 bis 32 auf einen Summierer 33 geführt, dessen Ausgang den Ausgang der Entzerrerbank bildet. Den zweiten Entzerrern 28 bis 32 sind weiterhin jeweils steuerbare Verstärker 34 bis 38 nachgeschaltet.

Die einzelnen ersten Entzerrer 23 bis 27 interferieren dabei komplexartig, das heißt, die Intensität der Interferenzen hängt auch von den eingehenden Phasen ab. Jeweils ein erster Entzerrer korrespondiert mit einem zweiten die Interferenzen korrigierenden zweiten Entzerrer 28 bis 32 derart, dass sie die selbe Mittenfrequenz aufweisen. Die Gesamtinterferenzwirkung benachbarter Entzerrer bei der Mittenfrequenz eines einzelnen ersten Entzerrers können entweder vereinfacht als eine reelle Zahl (Betrag) bei in etwa gleicher Phasenlage oder genauer als eine komplexe Zahl (Betrag und Phase)errechnet oder abgeschätzt werden.

Um das Ziel der Interferenzverminderung nur durch Einstellen der (reellen) Verstärkung des jeweiligen korrigierenden zweiten Entzerrers 28 bis 32 in einfacher Weise ohne Berücksichtigung der Phase, jedoch mit guter Näherung zu erreichen, wird dem ermittelten Verstärkungsbetrag (reeller Wert) gegebenenfalls mittels der steuerbaren Verstärker 34 bis 38 systematisch variiert und systematisch der Ausgang des jeweiligen zweiten Entzerrers gegebenenfalls mit einem umgekehrten Vorzeichen versehen (Phasenumkehr). Hierdurch wird die der Einfachheit halber außer acht gelassene Phasenbeziehung zu einem gewissen Grad doch Rechnung getragen.

**EP 1 235 346 B1**

**Patentansprüche**

1. Entzerreranordnung zum Erzeugen eines Ausgangssignals durch Entzerren eines Eingangssignals mit mindestens zwei miteinander interferierenden ersten Entzerrern (1 bis 6; 13 bis 17) und mindestens zwei korrigierenden zweiten Entzerrern (7 bis 12; 18 bis 22), die in Reihe zueinander geschaltet sind, wobei jeweils ein zweiter Entzerrer (7 bis 12; 18 bis 22) mit jeweils einem ersten Entzerrer (1 bis 6; 13 bis 17) korrespondiert derart, dass jeweils korrespondierende erste und zweite Entzerrer (1 bis 6; 13 bis 17; 7 bis 12; 18 bis 22) die im wesentlichen gleiche Mittenfrequenz haben, wobei die korrespondierenden zweiten Entzerrer ein die Interferenzen zumindest teilweise kompensierendes Entzerrungsverhalten aufweisen, und die Verstärkung des jeweils korrespondierenden zweiten Entzerrers (7 bis 12; 18 bis 22) bei der jeweiligen gemeinsamen Mittenfrequenz gleich der negativen Summe über die Verstärkung mindestens eines dem korrespondierenden ersten Entzerrer (1 bis 6; 13 bis 17) benachbarten ersten Entzerrers (1 bis 6; 13 bis 17) bei der Mittenfrequenz des korrespondierenden ersten Entzerrers (1 bis 6; 13 bis 17) ist.

2. Entzerreranordnung nach Anspruch 1, bei der sich die Verstärkung des jeweiligen zweiten Entzerrers (7 bis 12; 18 bis 22) aus den Verstärkungen des dem korrespondierenden ersten Entzerrers (1 bis 6; 13 bis 17) vorausgehenden ersten Entzerrers (1 bis 6; 13 bis 17) und des dem korrespondierenden ersten Entzerrer (1 bis 6; 13 bis 17) nachfolgenden ersten Entzerrers (1 bis 6; 13 bis 17) bei der Mittenfrequenz des korrespondierenden ersten Entzerrers (1 bis 6; 13 bis 17) zusammensetzt.

3. Entzerreranordnung nach Anspruch 2, bei der die Verstärkung des jeweiligen zweiten Entzerrers (7 bis 12; 18 bis 22) zudem auch die Verstärkungen weiterer benachbarter erster Entzerrer (1 bis 6; 13 bis 17) bei der Mittenfrequenz des korrespondierenden ersten Entzerrers (1 bis 6; 13 bis 17) beinhaltet.

4. Entzerreranordnung nach Anspruch 1, 2 oder 3, bei der die ersten Entzerrer (1 bis 6) jeweils unmittelbar hintereinander und die zweiten Entzerrer (7 bis 12) jeweils unmittelbar hintereinander geschaltet sind.

5. Entzerreranordnung nach Anspruch 1, 2, 3 oder 4, bei der jeweils ein erster Entzerrer (13 bis 17) und der zugehörige zweite Entzerrer (18 bis 22) unmittelbar hintereinander geschaltet sind.

6. Entzerreranordnung nach Anspruch 1, 2, 3 oder 4, bei der die ersten und zweiten Entzerrer (1 bis 6; 13 bis 17; 7 bis 12; 18 bis 22) jeweils eine Verstärkung aufweisen, die im wesentlichen konstant, jedoch im Bereich der Mittenfrequenz demgegenüber angehoben oder abgesenkt ist.

7. Entzerreranordnung nach einem der Ansprüche 1 bis 6, bei der die ersten Entzerrer (1 bis 6) eine parametrische Entzerrerbank bilden.

8. Entzerreranordnung nach einem der Ansprüche 1 bis 6, bei der die ersten Entzerrer (13 bis 17) eine grafische Entzerrerbank bilden.

9. Verfahren zum Erzeugen eines Ausgangssignals durch Entzerren eines Eingangssignals mit den Schritten:

   erstes Entzerren des Eingangssignals bei mindestens zwei Mittenfrequenzen mit einem bestimmten miteinander interferierenden Entzerrungsverhalten, korrespondierendes zweites Entzerren des Eingangssignals bei den selben mindestens zwei Mittenfrequenzen mit einem zu den resultierenden Interferenzen entgegengesetzten Entzerrungsverhalten, wobei die Verstärkung der jeweils korrespondierenden zweiten Entzerrungen bei der jeweiligen gemeinsamen Mittenfrequenz die negative Summe über die Verstärkung mindestens eines der korrespondierenden ersten Entzerrung benachbarten ersten Entzerrung bei der Mittenfrequenz der korrespondierenden ersten Entzerrung beinhaltet.

**Claims**

1. An equalizer device for producing an output signal by equalizing an input signal including at least two first equalizers (1 to 6; 13 to 17), which interfere with one another, and at least two correcting second equalizers (7 to 12; 18 to 22), which are connected together in series, a respective second equalizer (7 to 12; 18 to 22) corresponding with each first equalizer (1 to 6; 13 to 17) such that corresponding first and second equalizers (1 to 6; 13 to 17; 7 to 12; 18 to 22) have substantially the same centre frequency, the corresponding second equalizers having an equalizing performance which at least partially compensates for the interferences and the amplification of the respective corresponding second equalizers (7 to 12; 18 to 22) at the respective common centre frequency being equal to the negative total of the amplification of at least one first equalizer (1 to 6; 13 to 17) adjacent to the corresponding first equalizer (1 to 6; 13 to 17) at the centre frequency of the corresponding first equalizer (1 to 6; 13 to 17).

2. An equalizer device as claimed in Claim 1 in which the amplification of each second equalizer (7 to 12; 18 to 22) is made up from the amplifications of the first equalizer (1 to 6; 13 to 17) preceding the corresponding first equalizer (1 to 6; 13 to 17) and of the first equalizer (1 to 6; 13 to 17) following the corresponding first equalizer (1 to 6; 13 to 17) at the centre frequency of the corresponding first equalizer (1 to 6; 13 to 17).

3. An equalizer device as claimed in Claim 2 in which the amplification of each second equalizer (7 to 12; 18 to 22) also additionally includes the amplifications of further adjacent first equalizers (1 to 6; 13 to 17) at the centre frequency of the corresponding first equalizer (1 to 6; 13 to 17).

4. An equalizer device as claimed in Claim 1, 2 or 3 in which the first equalizers (1 to 6) are connected directly behind one another and the second equalizers (7 to 12) are connected directly in series.

5. An equalizer device as claimed in Claim 1, 2, 3 or 4 in which each first equalizer (13 to 17) and the associated second equalizer (18 to 22) are connected directly in series.

6. An equalizer device as claimed in Claim 1, 2, 3 or 4 in which the first and second equalizers (1 to 6; 13 to 17; 7 to 12; 18 to 22) each have an amplification which is substantially constant but is increased or reduced in the region of the centre frequency with respect thereto.

7. An equalizer device as claimed in one of Claims 1 to 6 in which the first equalizers (1 to 6) constitute a parametric equalizer bank.

8. An equalizer device as claimed in one of Claims 1 to 6 in which the first equalizers (13 to 17) constitute a graphic equalizer bank.

9. A method of producing an output signal by equalizing an input signal including the steps:

first equalization of the input signal at at least two centre frequencies with predetermined equalizing performances which interfere with one another, corresponding second equalization of the input signal at the same at least two centre frequencies with an equalization performance opposite to the resulting interferences, whereby the amplification of the corresponding second equalizations at the respective common centre frequency includes the negative sum of the amplification of at least one first equalization adjacent to the corresponding first equalization at the centre frequency of the corresponding first equalization.

**Revendications**

1. Agencement d'égaliseurs pour générer un signal de sortie par égalisation d'un signal d'entrée avec
au moins deux premiers égaliseurs en interférence mutuelle (1 à 6 ; 13 à 17) et au moins deux deuxièmes égaliseurs correcteurs (7 à 12 ; 18 à 22), montés en série l'un par rapport à l'autre,
respectivement un deuxième égaliseur (7 à 12 ; 18 à 22) correspondant avec respectivement un premier égaliseur (1 à 6 ; 13 à 17), de façon telle que
des premiers et des deuxièmes égaliseurs respectivement correspondants (1 à 6 ; 13 à 17 ; 7 à 12 ; 18 à 22) soient sensiblement à la même fréquence centrale, les deuxièmes égaliseurs correspondants ayant un comportement d'égalisation compensant au moins partiellement les interférences et
à la fréquence centrale respectivement commune, l'amplification du deuxième égaliseur respectivement correspondant (7 à 12 ; 18 à 22) soit identique à la somme négative de l'amplification d'au moins un premier égalisateur (1 à 6 ; 13 à 17), voisin du premier égalisateur correspondant (1 à 6 ; 13 à 17), à la fréquence centrale du premier égalisateur correspondant (1 à 6 ; 13 à 17).

2. Agencement d'égaliseurs selon la revendication 1, dans lequel l'amplification de respectivement le deuxième égaliseur (7 à 12 ; 18 à 22) est composée par les amplifications du premier égaliseur (1 à 6 ; 13 à 17) précédant le premier égaliseur correspondant (1 à 6 ; 13 à 17) et du premier égaliseur (1 à 6 ; 13 à 17) suivant le premier égaliseur correspondant (1 à 6 ; 13 à 17), à la fréquence centrale du premier égaliseur correspondant (1 à 6 : 13 à 17).

3. Agencement d'égaliseurs selon la revendication 2, dans lequel l'amplification de respectivement le deuxième égaliseur (7 à 12 ; 18 à 22) contient également par ailleurs les amplifications d'autres premiers égaliseurs voisins (1 à 6 ; 13 à 17) à la fréquence centrale du premier égaliseur correspondant (1 à 6 ; 13 à 17).

4. Agencement d'égaliseurs selon la revendication 1, 2 ou 3, dans lequel les premiers égaliseurs (1 à 6) sont respectivement montés directement les uns derrière les autres et les deuxièmes égaliseurs (7 à 12) sont respectivement montés directement les uns derrière les autres.

5. Agencement d'égaliseurs selon la revendication 1, 2, 3 ou 4, dans lequel respectivement un premier égaliseur (13 à 17) et le deuxième égaliseur associé (18 à 22) sont directement montés l'un derrière l'autre.

6. Agencement d'égaliseurs selon la revendication 1, 2, 3 ou 4, dans lequel les premiers et les deuxièmes égaliseurs (1 à 6 ; 13 à 17 ; 7 à 12 ; 18 à 22) ont chacun une amplification qui est sensiblement constante, mais qui dans la plage de la fréquence centrale est en revanche augmentée ou diminuée.

7. Agencement d'égaliseurs selon l'une quelconque des revendications 1 à 6, dans lequel les premiers égaliseurs (1 à 6) forment une banque d'atténuation paramétrique.

8. Agencement d'égaliseurs selon l'une quelconque des revendications 1 à 6, dans lequel les premiers égaliseurs (13 à 17) forment une banque d'atténuation graphique.

9. Procédé de génération d'un signal de sortie par égalisation d'un signal d'entrée, avec les étapes :

première égalisation du signal d'entrée, à au moins deux fréquences centrales, avec un comportement d'égalisation défini à interférence mutuelle,
deuxième égalisation correspondante du signal d'entrée, aux mêmes au moins deux fréquences centrales, avec un comportement d'égalisation opposé aux interférences résultantes, l'amplification des deuxièmes égalisations respectivement correspondantes à la fréquence centrale respectivement commune contenant la somme négative de l'amplification d'au moins l'une des premières égalisations voisine des premières égalisations correspondantes, à la fréquence centrale de la première égalisation correspondante.

FIG 1

FIG 2

FIG 3

a)

b)

c)

FIG 4

FIG 5

a)

b)

Frequenz (Hz)

FIG 6

FIG 7